# EUROPEAN PATENT APPLICATION

(11) **EP 4 230 764 A1**
(43) Date of publication of application: **23.08.2023**
(21) Application number: 21880016.7
(22) Date of filing: 08.10.2021
(51) Int. Cl.: C23C 16/42, H01L 21/3065

(54) **MEMBER FOR DEPOSITION DEVICE OR ETCHING DEVICE**

(30) Priority: 16.10.2020 JP 2020174611
(71) Applicant: AGC INC., Chiyoda-ku, Tokyo 1008405 (JP)
(72) Inventor: KAWAHARA, Koji, Tokyo 100-8405 (JP); OGAWA, Tomonori, Tokyo 100-8405 (JP)
(74) Representative: Müller-Boré & Partner Patentanwälte PartG mbB
(86) International application number: PCT/JP2021/037440
(87) International publication number: WO 2022/080277

(57) **Abstract**

A component for a film formation apparatus or an etching apparatus used for manufacturing semiconductors, the component including a disk-shaped or ring-shaped SiC film having an outer diameter of 300 mm or more and a thickness of 3 mm or more. The component does not include an interface extending perpendicularly to a thickness direction of the SiC film on an exposed side surface of the SiC film.

## Description

### TECHNICAL FIELD

The present invention relates to a component for a film formation apparatus or an etching apparatus.

### BACKGROUND ART

Components containing silicon carbide (SiC) are often used in apparatuses used for manufacturing semiconductors.

For example, various components such as a focus ring, a shower plate, a shield ring, and a susceptor are used in a plasma etching apparatus. Each of the components is composed of a substrate and a SiC film formed on the substrate. Alternatively, each of the components may be composed only of a SiC film.

For example, Patent Document 1 describes a method of manufacturing a ring-shaped component by forming a film of silicon carbide (SiC) on a carbon substrate using a thermal CVD method (Patent Document 1).

### PRIOR ART LITERATURE

### PATENT LITERATURE

Patent Document 1: Japanese Unexamined Patent Application Publication No. 2000-199063

### SUMMARY OF THE INVENTION

### PROBLEMS TO BE SOLVED BY THE INVENTION

When focus rings are mass-produced, a source gas is supplied into a reaction furnace in a state where a large number of substrates are placed in the heated reaction furnace. The source gas is decomposed and reacted in the reaction furnace to form a SiC film on each of the substrates, thereby focus rings are manufactured.

However, the inventors of the present invention have found that when large-sized focus rings having diameters exceeding 300 mm and thicknesses exceeding 3 mm are mass-produced by the above-described method, there are cases where considerable unevenness is formed on a side surface of the focus ring after polishing.

When the focus ring having such unevenness is used in a plasma etching apparatus, the side surface of the focus ring may become a generation source of particles in a plasma etching process of a wafer. Further, such particles may lead to contamination of a semiconductor apparatus.

These problems are not limited to the focus ring, and may equally occur in a component for a film formation apparatus or an etching apparatus including a similar SiC film.

The present invention has been made in view of the above-described background, and an object of the present invention is to provide a component for a film formation apparatus or an etching apparatus capable of significantly suppressing an occurrence of contamination due to particles when manufacturing a semiconductor apparatus.

### MEANS FOR SOLVING THE PROBLEM

According to an aspect of the present invention, a component for a film formation apparatus or an etching apparatus used for manufacturing semiconductors, the component including
a disk-shaped or ring-shaped SiC film having an outer diameter of 300 mm or more and a thickness of 3 mm or more,
the component not including an interface extending perpendicularly to a thickness direction of the SiC film on an exposed side surface of the SiC film, is provided.

### EFFECTS OF THE INVENTION

According to the present invention, it is possible to provide a component for a film formation apparatus or an etching apparatus capable of significantly suppressing an occurrence of contamination due to particles when manufacturing a semiconductor apparatus.

### BRIEF DESCRIPTION OF THE DRAWINGS

[FIGURE 1] FIG. 1 is a cross-sectional view schematically showing a typical structure cross-section of a conventional focus ring.
[FIGURE 2] FIG. 2 is a top view schematically showing a component according to an embodiment of the present invention.
[FIGURE 3] FIG. 3 is a diagram schematically showing a cross-section taken along a line A-A of the component shown in FIG. 2.
[FIGURE 4] FIG. 4 is a top view schematically showing a component according to another embodiment of the present invention.
[FIGURE 5] FIG. 5 is a diagram schematically showing a cross-section taken along a line B-B of the component shown in FIG. 4.
[FIGURE 6] FIG. 6 is a diagram schematically showing an example of a configuration of an apparatus that can be used when manufacturing the component according to the embodiment of the present invention.
[FIGURE 7] FIG. 7 is a photograph showing a part of a cross section of Sample 1.
[FIGURE 8] FIG. 8 is a photograph showing a part of a cross section of Sample 2.
[FIGURE 9] FIG. 9 is a photograph showing a part of a cross section of Sample 3.
[FIGURE 10] FIG. 10 is a photograph showing a part of a cross section of Sample 4.
[FIGURE 11] FIG. 11 is a photograph showing a part of a cross section of Sample 5.

### MODE FOR CARRYING OUT THE INVENTION

Hereinafter, an embodiment of the present invention will be described.

As described above, the inventors of the present invention have found that when large-sized focus rings having diameters exceeding 300 mm and thicknesses exceeding 3 mm are mass-produced by the conventional method, considerable unevenness is formed on a side surface of the focus ring after polishing. Such unevenness on the side surface of the focus ring may adversely affect a quality of a semiconductor product.

According to the consideration of the present inventors, a cause of the unevenness is considered as follows.

When the focus ring is industrially mass-produced, a large number of substrates are disposed in a reaction furnace. In addition, a source gas for SiC film formation is supplied from a gas introduction pipe to the heated reaction furnace. The gas introduction pipe is usually provided on the upper portion or on the side wall portion of the reaction furnace.

The source gas supplied from the gas introduction pipe then reaches each substrate. However, since distances from the tip of the gas introduction pipe to the respective substrates are different from each other, time periods until the source gas reaches the respective substrates are different from each other. As a result, a thickness of the SiC film is different for each substrate.

In particular, the above-described influence becomes more evident when large-sized focus rings having diameters exceeding 300 mm and thicknesses exceeding 3 mm are mass-produced.

Therefore, in order to reduce the difference in the film formation rate among the substrates, the film formation is once interrupted and the positions of the substrates are changed. Thereafter, the same film formation process is continued. The number of times of the above-described position change varies depending on the required thickness of the SiC film, but the position change may be performed a plurality of times.

In the focus ring formed through the above-described interruption process, an interface is generated in the SiC film along a direction substantially perpendicular to the growth direction of the film. The number of generated interfaces is equal to the number of times of the interruption of the film formation.

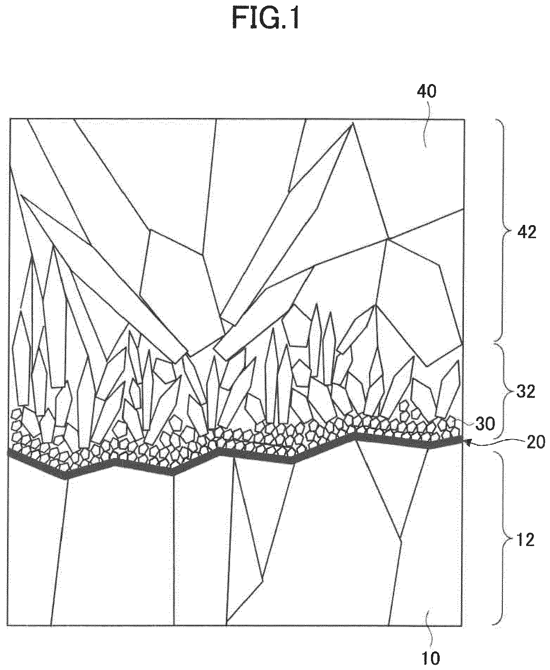

FIG. 1 schematically shows a typical structure cross-section of a conventional focus ring including an interface.

As shown in FIG. 1, when the film formation is interrupted halfway, the growth of the SiC film is stopped, and a first region 12 including a large number of columnar crystal grains (single crystals) 10 is formed. A line connecting tips of the first regions 12 is an "interface" 20. Thereafter, when the formation of the SiC film is resumed, the crystal of SiC grows again along the direction perpendicular to the thickness direction via the interface 20. In this case, however, a transition region 32 including a large number of relatively small crystal grains 30 is formed on the interface 20. Thereafter, a second region 42 including a large number of columnar large crystal grains (single crystals) 40 such as the initial crystal grains 10 is formed on the transition region 32.

When the film formation is interrupted halfway as described above, a SiC film having the structure as shown in FIG. 1 is generally formed.

As a result of the above-described interface being exposed on the side surface of the focus ring, it is considered that the above-described problem occurs. That is, when the interface is exposed on the side surface of the focus ring, because the strength of the interface portion is different from that of the surrounding portion, it is difficult to cause the side surface to have a uniform strength. Therefore, it is considered that when the side surface of the focus ring is polished, unevenness is generated on the side surface.

The inventors of the present application have completed the present invention based on the above consideration.

That is, according to an embodiment of the present invention, a component for a film formation apparatus or an etching apparatus used for manufacturing semiconductors, the component including
a disk-shaped or ring-shaped SiC film having an outer diameter of 300 mm or more and a thickness of 3 mm or more,
the component not including an interface extending perpendicularly to a thickness direction of the SiC film on an exposed side surface of the SiC film,
is provided.

In the present application, the expression "perpendicular to the thickness direction" means that not only the angle with respect to the thickness direction of just 90° but also a range of the angle of from 75° to 105° with respect to the thickness direction are included.

The component according to one embodiment of the present invention may have the outer diameter being greater than or equal to 350 mm, for example, greater than or equal to 400 mm. In addition, the component according to one embodiment of the present invention may have the thickness of greater than or equal to 3.5 mm, for example, greater than or equal to 4 mm.

The diameter of the component according to one embodiment of the present invention may be, for example, less than or equal to 800 mm. In addition, the thickness of the component according to one embodiment of the present invention may be, for example, less than or equal to 20 mm.

The component according to one embodiment of the present invention is manufactured by forming a SiC film and then performing a machine processing for the SiC film.

Here, in one embodiment of the present invention, as will be described later, an interface is not included in an exposed side surface even in the SiC film immediately after the film formation. Therefore, in one embodiment of the present invention, the component can be uniformly processed, and unevenness that may occur on the side surface during the processing can be significantly suppressed.

In one embodiment of the present invention, the exposed side surface of the SiC film after polishing also does not include an interface. Therefore, in one embodiment of the present invention, it is possible to significantly suppress the risk that the side surface of the component becomes a generation source of particles in the process of manufacturing semiconductor devices.

In particular, in one embodiment of the present invention, an interface extending perpendicularly to the thickness direction of the SiC film is preferably not included inside the SiC film.

Here, it is possible to determine whether an interface is present on the exposed side surface of the SiC film by observing the side surface of the processed component in a product state.

On the other hand, it is not possible to determine whether the component has an interface inside the SiC film from its appearance. In the present application, determining whether the component has an interface in the SiC film is performed as follows.

The component to be evaluated is divided into four equal parts so as to pass through the center C of the component. Both cross sections of each of the obtained fan-shaped pieces are polished until no cutting marks are left. In each polished surface (hereinafter referred to as "observation surface") (eight surfaces in total), a presence or absence of an interface extending in a direction substantially perpendicular to the thickness direction of the SiC film is evaluated. When such an interface is observed in one or more observation surfaces among the eight surfaces, it is determined that the component to be evaluated has an interface inside the SiC film.

As described above, the component according to one embodiment of the present invention is not limited to the focus ring. The component according to one embodiment of the present invention may be provided as a component for a film formation apparatus or an etching apparatus, for example, a shower plate, a shield ring, a susceptor, or the like.

The component according to one embodiment of the present invention may include a substrate and a SiC film provided on the substrate. Alternatively, the component according to one embodiment of the present invention may not include a substrate and be formed of a SiC film.

When the component according to one embodiment of the present invention has a substrate, the substrate may be composed of, for example, carbon, silicon (Si), a SiC sintered body, or a SiC-Si composite material.

### (Component according to one embodiment of the present invention)

Next, the component according to one embodiment of the present invention will be described in more detail with reference to the drawings.

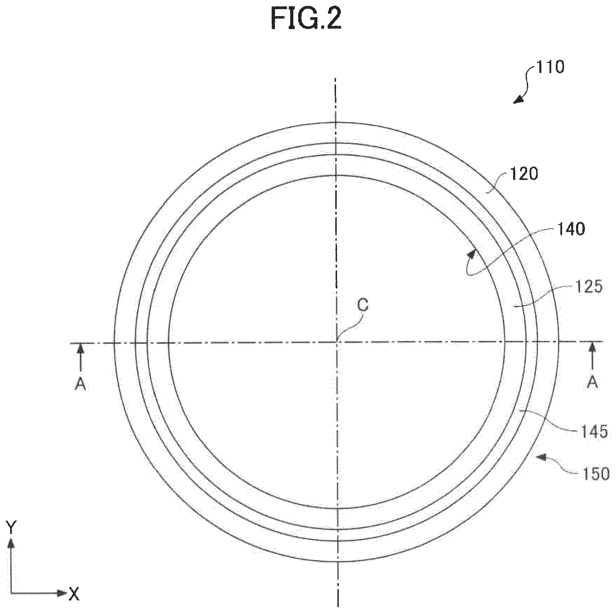

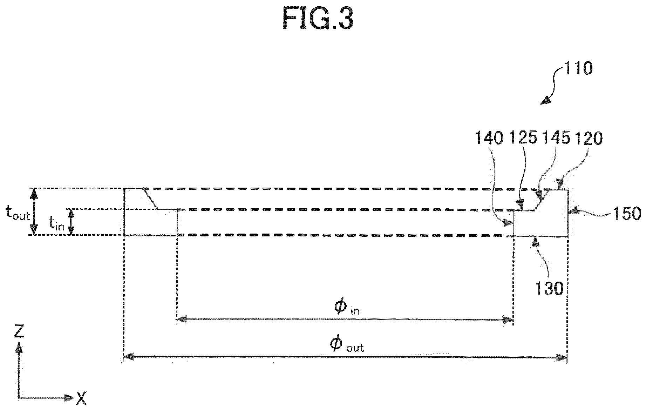

FIG. 2 is a top view schematically showing the component according to one embodiment of the present invention. FIG. 3 is a diagram schematically showing a cross section of the component taken along a line A-A shown in FIG. 2.

As shown in FIGS. 2 and 3, in this example, the component according to one embodiment of the present invention is provided as a focus ring 110.

The focus ring 110 is disposed so as to surround an outer periphery of a wafer in a plasma etching apparatus, for example. By using the focus ring 110, a plasma formed above the wafer may be stabilized over an entire upper surface of the wafer.

As shown in FIGS. 2 and 3, the focus ring 110 has a circular ring shape. The focus ring 110 has an upper surface 120 and a lower surface 130 which are parallel to each other, and an intermediate surface 125 which is provided between height levels of the upper surface 120 and the lower surface 130 and is parallel to both the surfaces. The focus ring 110 has a first inner side surface 140 and an outer side surface 150 which are parallel to each other. Further, the focus ring 110 has a second inner side surface 145, which is between the intermediate surface 125 and the upper surface 120 that connects both the surfaces.

An outer diameter φₒᵤₜ of the focus ring 110 is greater than or equal to 300 mm, and, for example, greater than or equal to 350 mm. The outer diameter φₒᵤₜ may be, for example, 400 mm, 500 mm, 600 mm, or 700 mm. The maximum value of the outer diameter φₒᵤₜ is not particularly limited, but is less than or equal to 800 mm, for example.

In addition, an inner diameter φᵢₙ of the focus ring 110 is not particularly limited, but is, for example, in a range of 40 mm to 450 mm.

A height of the outer side surface 150 of the focus ring 110, that is, a thickness tₒᵤₜ of the focus ring 110 is greater than or equal to 3 mm, and, for example, greater than or equal to 3.5 mm. The thicknesses tₒᵤₜ may be, for example, 4 mm, 5 mm, 6 mm, or 7 mm. The maximum value of the thickness tₒᵤₜ is not particularly limited, but is less than or equal to 20 mm, for example.

In addition, a height of the first inner side surface 140 of the focus ring 110, that is, a distance tᵢₙ from the intermediate surface 125 to the lower surface 130, is not particularly limited, but is, for example, in a range of 1 mm to 7 mm.

Note that these dimensions are merely examples for grasping an image of the shape of the focus ring 110, and the focus ring 110 may have dimensions other than those described above as long as the outer diameter φₒᵤₜ is greater than or equal to 300 mm and the thickness tₒᵤₜ is greater than or equal to 3 mm.

The focus ring 110 is characterized in that each of the SiC film portions of the first inner side surface 140, the second inner side surface 145, and the outer side surface 150 does not include an interface extending in a direction substantially perpendicular to the growth direction of the film. In particular, it is preferable that the focus ring 110 does not include an interface in the SiC film.

The above-described focus ring 110 is manufactured by forming a SiC film and then performing a machine processing for the SiC film. The machine processing includes any of processing, such as cutting processing, grinding processing, and polishing, or a combination thereof.

Here, the focus ring 110 does not include an interface on the exposed side surface even at the stage of the SiC film immediately after the film formation (hereinafter, referred to as "unprocessed focus ring"). Therefore, the side surface of the unprocessed focus ring can be processed relatively uniformly, and unevenness that may occur on the side surface can be significantly suppressed.

Therefore, for the focus ring 110 manufactured by processing the unprocessed focus ring it is possible to significantly suppress the risk that the first inner side surface 140, the second inner side surface 145, and the outer side surface 150 become a generation source of particles in the manufacturing process of semiconductor devices.

In addition, in a cross section obtained by cutting the focus ring 110 so as to pass through the center C and performing polishing or machining, a surface roughness (measured as the maximum height Rz) may be, for example, 1.5 µm or less.

The maximum height Rz of the cross section is measured as follows.

The cross-section of the focus ring 110 is mechanically polished with a diamond grindstone, and then polished with diamond slurry of 1 µm. Further, buffing using colloidal silica is performed to mirror-finish the cross section. Next, the maximum height Rz is measured from the lower surface 130 to the upper surface 120 of the focus ring 110 along the thickness direction (Z direction in FIG. 3) at any point on the polishing surface.

The maximum height Rz is preferably 1.0 um or less, more preferably 0.5 um or less, even more preferably 0.3 µm or less, and particularly preferably 0.1 µm or less.

In the cross section, the Vickers hardness may be, for example, 500 HV1.0 or more. The Vickers hardness is measured by the method described in JIS R1610 (Test methods for hardness of fine ceramics). HV1.0 is a hardness symbol indicating that the Vickers hardness is measured at a test force of 1.0 kgf.

The Vickers hardness is preferably 1000 HV1.0 or more, more preferably 1300 HV1.0 or more, even more preferably 1500 HV1.0 or more, and particularly preferably 2000 HV1.0 or more.

In the example shown in FIGS. 2 and 3, the focus ring 110 is formed of a SiC film. However, the focus ring 110 may be formed of a substrate and a SiC film disposed on the substrate.

As the substrate, for example, carbon, silicon (Si), a SiC sintered body, a SiC-Si composite material, or the like is used.

When the focus ring 110 includes the substrate, the above-described measurement of the maximum height Rz is performed in a region which does not include the substrate.

As described above, the feature of the component according to the embodiment of the present invention, that is, the focus ring 110 has been described. However, the configuration shown in FIGS. 2 and 3 is merely an example, and the focus ring according to the embodiment of the present invention may have a different configuration. For example, a configuration in which the intermediate surface 125 and the second inner side surface 145 are not present in the focus ring 110 is also assumed. In this case, the first inner side surface 140 and the outer side surface 150 have the same thickness (i.e., tₒᵤₜ=tᵢₙ) .

### (Component according to another embodiment of the present invention)

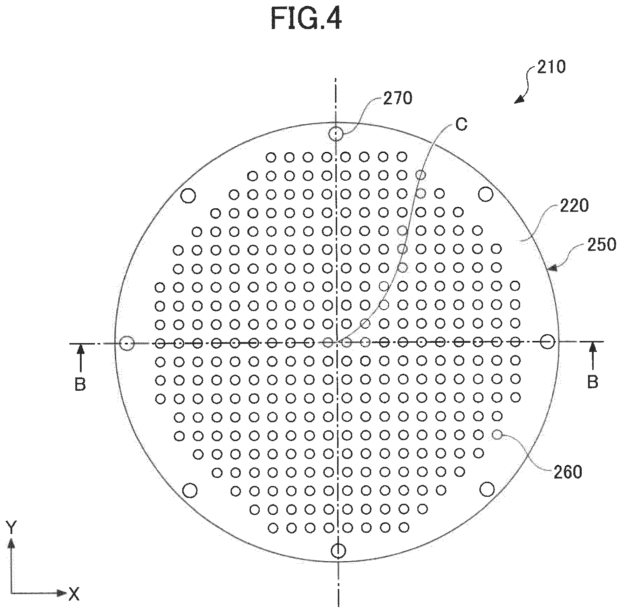

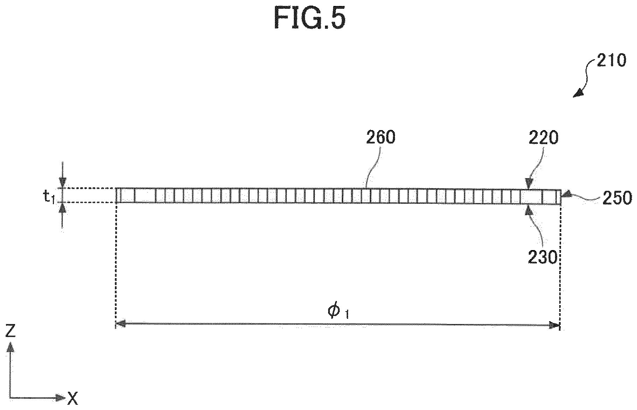

Next, referring to FIGS. 4 and 5, a component according to another embodiment of the present invention will be described in detail.

FIG. 4 is a top view schematically showing a component according to another embodiment of the present invention. FIG. 5 is a diagram schematically showing a cross section of the component taken along a line B-B shown in FIG. 4.

As shown in FIGS. 4 and 5, in this example, a component according to the embodiment of the present invention is provided as a shower plate 210.

The shower plate 210 is disposed above a wafer in a plasma etching apparatus, for example. By using the shower plate 210, etching gas can be uniformly supplied to the entire surface of the wafer.

As shown in FIGS. 4 and 5, the shower plate 210 has a disk shape. The shower plate 210 has an upper surface 220 and a lower surface 230 which are parallel to each other, and an outer side surface 250.

In addition, a large number of gas discharge ports 260 penetrating from the upper surface 220 to the lower surface 230 are provided substantially at the center of the shower plate 210 in a top view. A plurality of through holes 270 are provided on the outer peripheral side of the shower plate 210 in the top view. These through holes 270 are used when the shower plate 210 is fixed to another component.

The outer diameter φ₁ of the shower plate 210 is greater than or equal to 300 mm, for example, greater than or equal to 350 mm. The outer diameter φ₁ may be, for example, 400 mm, 500 mm, 600 mm, or 700 mm. The maximum value of the outer diameter φ₁ is not particularly limited, but is less than or equal to 800 mm, for example.

A height of the outer side surface 250 of the shower plate 210, that is, a thickness t₁ of the shower plate 210 is greater than or equal to 3 mm, and, for example, greater than or equal to 3.5 mm. The thickness t₁ may be, for example, 4 mm, 5 mm, 6 mm, 7 mm, 8 mm, or 10 mm. The maximum value of the thickness t₁ is not particularly limited, but is, for example, less than or equal to 20 mm.

In the example shown in FIGS. 4 and 5, the shower plate 210 is formed of a SiC film. However, the shower plate 210 may be configured by a substrate and a SiC film disposed on the substrate. As the substrate, the material as described above is used.

The shower plate 210 is characterized in that the SiC film portion of the outer side surface 250 does not include an interface extending substantially perpendicular to the growth direction of the film. In particular, the shower plate 210 preferably does not include an interface also in the SiC film.

The above-described shower plate 210 is manufactured by forming a SiC film and then machining the SiC film.

Here, the shower plate 210 does not include an interface on the exposed side surface even at the stage of the SiC film immediately after the film formation (hereinafter referred to as "unprocessed shower plate"). Therefore, the side surface of the unprocessed shower plate can be processed relatively uniformly, and unevenness that may occur on the side surface can be significantly suppressed.

Therefore, for the shower plate 210 manufactured by processing the unprocessed shower plate it is possible to significantly suppress the risk that the outer side surface 250 becomes a generation source of particles in the manufacturing process of the semiconductor devices.

In a cross section obtained by cutting the shower plate 210 so as to pass through the center C and performing polishing or machining, a surface roughness (maximum height Rz) measured as described above may be, for example, 1.5 µm or less.

The maximum height Rz is preferably 1.0 µm or less, more preferably 0.5 µm or less, even more preferably 0.3 um or less, and particularly preferably 0.1 µm or less.

In the cross section, the Vickers hardness measured as described above may be, for example, 500 HV1.0 or more.

The Vickers hardness is preferably 1000 HV1.0 or more, more preferably 1300 HV1.0 or more, even more preferably 1500 HV1.0 or more, and particularly preferably 2000 HV1.0 or more.

As described above, an example of the component according to the embodiment of the present invention has been described with reference to FIGS. 2 to 5.

However, it should be noted that the components according to the embodiment of the present invention are not limited to the focus ring and the shower plate, and may be provided as a shield ring and/or a susceptor.

### (Method of manufacturing component according to one embodiment of the present invention)

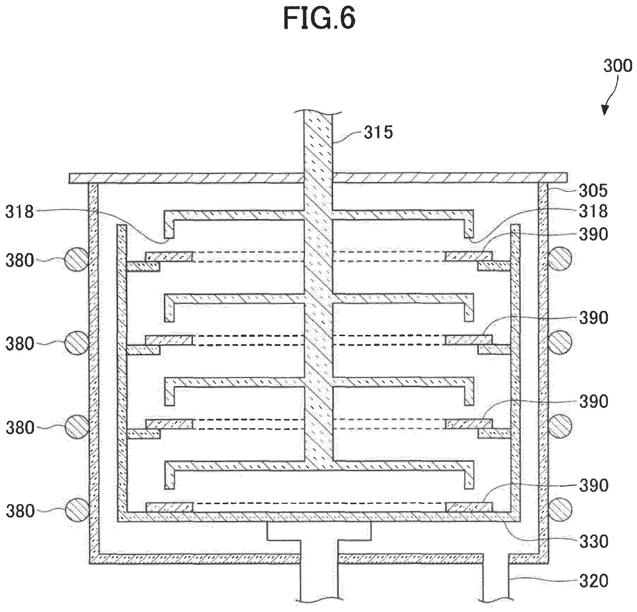

Next, an example of a method of manufacturing a component according to one embodiment of the present invention will be described with reference to FIG. 6. Here, as an example, in a case where the component according to one embodiment of the present invention is the focus ring 110 as shown in FIGS. 2 and 3, a method of manufacturing the component will be described.

FIG. 6 illustrates a configuration example of an apparatus 300 that may be used for manufacturing the focus ring 110.

As shown in FIG. 6, the apparatus 300 has a configuration capable of manufacturing the plurality of focus rings 110 having a large size at the same time.

Specifically, the apparatus 300 includes a housing 305, a gas supply pipe 315 connected to the housing 305, and an exhaust pipe 320.

An inside of the housing 305 is used as a space for forming a SiC film by a thermal CVD method. Therefore, a holder 330 in which a plurality of substrates 390 can be placed is accommodated in the housing 305. The substrates 390 are stacked in the holder 330 so as to be spaced apart from each other.

In the example shown in FIG. 6, the holder 330 can accommodate and hold four substrates 390 along the height direction. However, the number of substrates 390 accommodated in the holder 330 is not particularly limited. In particular, when focus rings 110 are actually mass-produced, a larger number of substrates 390 are accommodated in the holder 330.

The holder 330 is made of a heat-resistant material such as carbon or SiC. Note that the holder 330 may or may not have a function of rotating the substrate 390.

The gas supply pipe 315 is provided to supply a source gas for thermal CVD into the housing 305.

The gas supply pipe 315 has a plurality of gas outlets 318. Each gas outlet 318 is located proximate to the substrate 390, which is a target.

In particular, the gas supply pipe 315 is configured such that a plurality of gas outlets 318 are assigned to one substrate 390. For example, in the example shown in FIG. 6, two gas outlets 318 are arranged symmetrically with respect to one ring-shaped substrate 390.

Both the gas supply pipe 315 and the gas outlet 318 are made of insulating ceramics or the like.

The apparatus 300 further includes a heating means 380 outside the housing 305 for heating the substrate 390. The heating means 380 may be, for example, means for heating the substrate 390 by an induction heating method, such as a coil. Alternatively, the heating means 380 may be means for optically heating the substrate 390, for example, a laser heating means.

When the focus ring 110 is manufactured by using the apparatus 300, first, a plurality of substrates 390 are accommodated in the holder 330. The holder 330 is installed in the housing 305.

As described above, the holder 330 is disposed in the housing 305 such that a plurality of gas outlets 318 connected to the gas supply pipe 315 are assigned to each substrate 390.

Next, after the inside of the housing 305 is sealed, the pressure inside the housing 305 is adjusted. The adjusted pressure ranges, for example, from 100 torr to 800 torr. The substrate 390 is heated by the heating means 380.

Next, a source gas is introduced into the gas supply pipe 315.

The source gas is not particularly limited as long as a SiC film can be formed on the substrate 390. For example, a mixed gas containing methyl trichlorosilane, hydrogen, silicon tetrachloride, and methane may be used.

The source gas is discharged from each gas outlet 318 toward the corresponding substrate 390. Thereby, a thermal CVD reaction occurs in the vicinity of the substrate 390, and a SiC film can be formed on the surface of the substrate 390.

After the film formation process is performed for a predetermined time, the substrate 390 is taken out from the housing 305, and the unprocessed focus ring is collected. Thereafter, the unprocessed focus ring is processed, so that the focus ring 110 can be manufactured.

If necessary, the substrate 390 may be removed, and the focus ring 110 may be formed only of a SiC film.

In a conventional method of mass-producing focus rings, it is necessary to change a position of the substrate at least once during the film formation. This is because, in a conventional manufacturing apparatus, distances from a tip of a gas introduction pipe to the respective substrates are different from each other, and as a result, a film thickness of SiC is different for each substrate.

By changing the position of the substrate, it is possible to adjust a variation in the film thickness among the substrates.

However, in order to change the position of the substrate, it is necessary to once stop the film formation. Therefore, in the conventional manufacturing method, one interface is generated or two or more interfaces are generated in the completed SiC film depending on a number of times of stopping the film formation. In addition, when the unprocessed focus ring including such an interface is polished, since a strength of the inner side surface (and the outer side surface) is not uniform, unevenness is generated on the inner side surface (and the outer side surface). Such unevenness may cause contamination by particles.

In contrast, in the apparatus 300, at least two gas outlets 318 are assigned to each substrate 390, and the gas outlets 318 are arranged close to the substrate 390. Therefore, when the film formation of SiC is performed using the apparatus 300, the position change is not necessary, and the film formation of SiC can be continuously performed. Therefore, a SiC film having no interface can be formed.

As a result, each of the first inner side surface 140, the second inner side surface 145, and the outer side surface 150 of the unprocessed focus ring has uniform strength, and uniform processing can be performed in a subsequent processing step. Therefore, even in the focus ring 110 obtained after the processing step, unevenness on the first inner side surface 140, the second inner side surface 145, and the outer side surface 150 can be significantly suppressed.

Also in the conventional manufacturing apparatus, in order to reduce the distance between the gas outlet and the substrate in a reaction space, it is conceivable to extend the gas supply pipe to the vicinity of the substrate. However, in the conventional manufacturing apparatus, since the reaction space is uniformly heated by the heater, in such a configuration, the gas outlet is heated to the same temperature as the substrate. As a result, a reaction of the source gas may occur in the pipe, and a risk of clogging increases.

On the other hand, in the apparatus 300, a method of selectively heating the substrate 390 is employed instead of a method of uniformly heating the inside of the housing 305. For example, in the example shown in FIG. 6, both the gas supply pipe 315 and the gas outlet 318 are made of insulating ceramics or the like, and the substrate 390 is selectively heated by induction heating.

As described above, in the apparatus 300, the gas supply pipe 315 and the gas outlets 318 are significantly prevented from being heated by the heating means 380. Thus, in the apparatus 300, the risk of the gas supply pipe 315 and the respective gas outlets 318 becoming clogged can be significantly reduced.

As described above, the method of manufacturing the component according to one embodiment of the present invention has been described by taking the apparatus 300 and the focus ring 110 as an example.

However, the above description is merely an example, and the focus ring 110 may be manufactured by other apparatuses. In addition, a component including a SiC film, other than the focus ring 110, for example, a shower plate 210, a shield ring, and a susceptor, may be manufactured by the same method.

### EXAMPLES

In order to confirm the effect of the configuration according to the embodiment of the present invention, the following experiment was performed.

### (Samples 1 to 5)

Under the conditions shown in TABLE 1, a source gas was supplied from a nozzle in a state where a substrate made of graphite placed in a reaction furnace was heated, and a SiC film was formed on one surface of the substrate by a thermal CVD method to prepare Samples 1 to 5.

Here, in the preparation of Samples 1, 2 and 5, the gas was supplied from a gas outlet at a tip portion of the nozzle provided above the center of the substrate. For Sample 3 or 4, the gas was supplied from a shower head type nozzle, provided above the substrate and having a plurality of gas outlets in a plane parallel to a surface of the substrate. The gas outlets were arranged at regular intervals so that a film could be formed uniformly on the surface of the substrate. In TABLE 1, "distance from substrate surface to gas outlet" means the shortest distance between the surface of the substrate and the gas outlet, and for Sample 3 or 4, all the gas outlets had substantially the same shortest distance from the surface of the substrate.

In addition, in the preparation of Sample 5, after 5 hours from the start of the film formation of SiC, the film formation was once suspended, an interval of 30 minutes was provided, and then the film formation of SiC was performed again for 5 hours under the same condition.

**[TABLE 1]**

| Samp le | Substrate | | | | Reaction furnace | | Source gas (sccm) | | | Film formation condition | | | Thickness of obtained SiC film (mm) |
|---|---|---|---|---|---|---|---|---|---|---|---|---|---|
| | Outer diame ter (mm) | Thick ness (mm) | Temper ature (°C) | Rotation al speed (rpm) | Volume (L) | Pressur e (Torr) | SiCl₄ | CH₄ | H₂ | Number of nozzles | Distance from substrate surface to gas outlet (mm) | Film formation time (hrs) | |
| 1 | 70 | 60 | 1550 | 0 | 20 | 700 | 170 | 170 | 1,700 | 1 | 15 | 10 | 10 |
| 2 | 70 | 60 | 1550 | 0 | 20 | 700 | 300 | 360 | 1,830 | 1 | 30 | 7 | 12 |
| 3 | 70 | 60 | 1550 | 0 | 20 | 500 | 240 | 290 | 1,470 | 34 | 25 | 2.7 | 6 |
| 4 | 300 | 30 | 1450 | 0.001 | 500 | 700 | 6,800 | 8,300 | 42,000 | 58 | 50 | 6 | 4 |
| 5 | 70 | 60 | 1550 | 0 | 20 | 700 | 170 | 170 | 1,700 | 1 | 15 | 10 | 10 |

### (Evaluation)

Evaluations were performed using Samples 1 to 5 as follows.

### (Observation of Side Surface)

In each of Samples 1 to 5, a side surface was machined using a grinding apparatus, and then shape observation was performed.

The side surfaces of both samples were polished using diamond slurry and colloidal silica slurry.

When a SiC film portion was visually observed on the side surface after polishing, presence of an interface was not recognized in Samples 1 to 4. On the other hand, in Sample 5, it was found that an interface was present in the SiC film portion.

### (Observation of Cross Section)

Each sample was cut so as to pass through substantially the center, and a cut sample was collected. Hereinafter, the cut samples collected from Samples 1 to 5 will be referred to as cut samples 1 to 5, respectively.

In the cut samples 1 to 5, a cross section of the SiC film was observed using a microscope. Note that a number of cut samples collected from each sample was one.

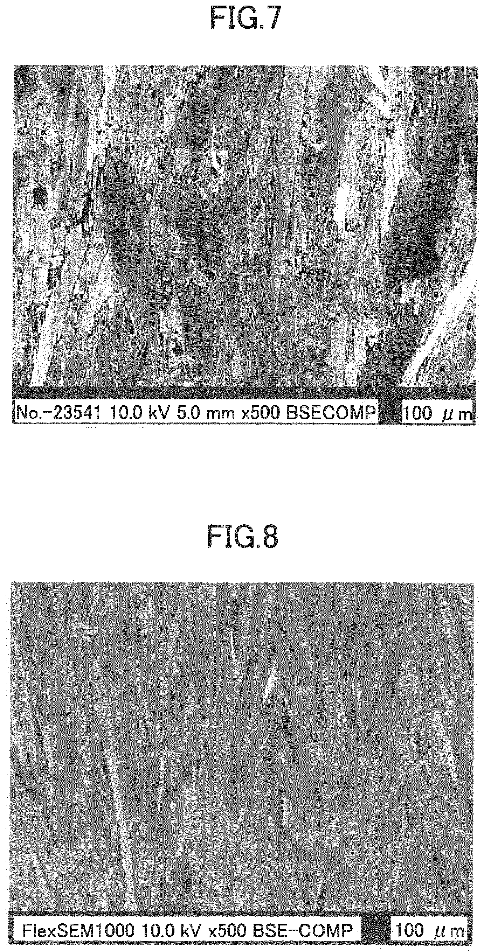

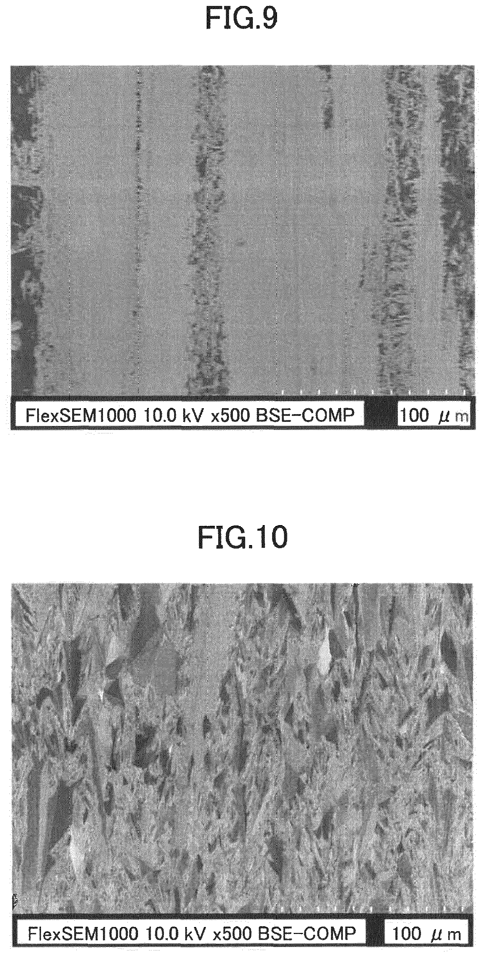

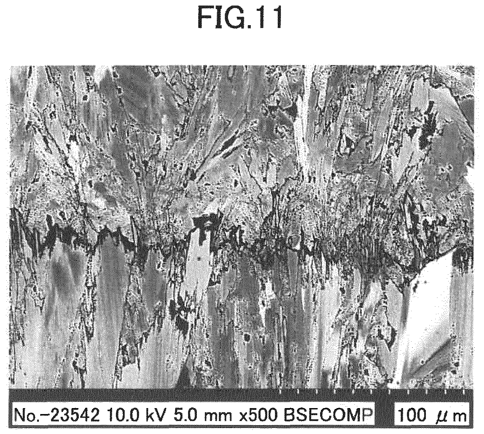

FIGS. 7 to 11 show examples of photographs of cross sections of cut samples 1 to 5 collected from samples 1 to 5.

As is clear from these photographs, no interface was observed in the SiC film in the cut samples 1 to 4. On the other hand, in the cut sample 5, a portion where crystal growth was discontinuous, that is, an interface, was observed in the SiC film. It was observed that the interface extended perpendicularly to the growth direction of the film.

### (Measurement of Roughness of Cross Section)

A roughness of cross section was evaluated using the above-described cut samples 1 to 5. As an index of the roughness of cross section, a maximum height Rz measured by the above-described procedure was employed.

The measurement was performed at three different points in one sample.

TABLE 2, shown below, summarizes results obtained for the cut samples 1 to 5.

**[TABLE 2]**

| | Maximum height Rz (µm) | | | |
|---|---|---|---|---|
| | First measurement | Second measurement | Third measurement | Average |
| Cut sample 1 (Sample 1) | 0.176 | 0.121 | 0.112 | 0.136 |
| Cut sample 2 (Sample 2) | 0.018 | 0.017 | 0.020 | 0.019 |
| Cut sample 3 (Sample 3) | 0.006 | 0.003 | 0.005 | 0.005 |
| Cut sample 4 (Sample 4) | 0.182 | 0.131 | 0.117 | 0.144 |
| Cut sample 5 (Sample 5) | 1.643 | 1.541 | 2.261 | 1.815 |

As described above, in Sample 5, it was found that an interface was generated in the SiC film and the unevenness of the cross section was large. On the other hand, in Samples 1 to 4, it was confirmed that no interface was observed in the SiC film and that the unevenness of the cross section was significantly suppressed.

### (Measurement of Vickers hardness)

The Vickers hardness was evaluated using the cut samples 1 to 5 described above. As a measurement method, the method described in JIS R1610 (Test methods for hardness of fine ceramics) was adopted.

In each of the cut samples 1 to 4, measurement was performed at five different positions in the cross section of one sample, and an average value thereof was calculated. In the cut sample 5, measurement was performed at five different points in the vicinity of the interface in the SiC film in the cross section of the sample, and an average value thereof was calculated.

TABLE 3, shown below, summarizes results obtained for the cut samples 1 to 5.

**[TABLE 3]**

| | Vickers hardness (HV 1.0) (average value) |
|---|---|
| Cut sample 1 | 2419 |
| Cut sample 2 | 2718 |
| Cut sample 3 | 1377 |
| Cut sample 4 | 2198 |
| Cut sample 5 | 376 |

As shown in TABLE 3, in the cut samples 1 to 4, the average value of the Vickers hardness was a high value of 1000 HV1.0 or more, whereas in the cut sample 5, the average value of the Vickers hardness was a significantly low value of 376 HV1.0. That is, it is suggested that in Samples 1 to 4, scratches are less likely to occur as compared with Sample 5, and thus occurrence of contamination due to particles can be significantly suppressed.

In addition, as is clear from the above-described results of evaluation, Sample 4 in which the outer diameter was 300 mm was excellent in roughness of cross section and in Vickers hardness compared to Sample 5, similarly to Samples 1 to 3 in which the outer diameter was 70 mm. That is, it was shown that by appropriately adjusting the various conditions shown in TABLE 1, it is possible to form a SiC film having an outer diameter greater than or equal to 300 mm, a thickness greater than or equal to 3 mm, and no interface extending perpendicularly to the thickness direction.

The present application claims priority under Japanese Patent Application No. 2020-174611 filed on October 16, 2020, the entire contents of which are incorporated in the present application by reference.

### Description of reference signs

- 10: Columnar crystal grains
- 12: First region
- 20: Interface
- 30: Small crystal grains
- 32: Transition region
- 40: Columnar crystal grains
- 42: Second region
- 110: Focus ring
- 120: Upper surface
- 125: Intermediate surface
- 130: Lower surface
- 140: First inner side surface
- 145: Second inner side surface
- 150: Outer side surface
- 210: Shower plate
- 220: Upper surface
- 230: Lower surface
- 250: Outer side surface
- 260: Gas discharge port
- 270: Through hole
- 300: Apparatus
- 305: Housing
- 315: Gas supply pipe
- 318: Gas outlet
- 320: Exhaust pipe
- 330: Holder
- 380: Heating means
- 390: Substrate

## Claims

1. A component for a film formation apparatus or an etching apparatus used for manufacturing semiconductors, the component comprising:
a disk-shaped or ring-shaped SiC film having an outer diameter of 300 mm or more and a thickness of 3 mm or more,
wherein the component does not include an interface extending perpendicularly to a thickness direction of the SiC film on an exposed side surface of the SiC film.

2. The component according to claim 1,
wherein the component does not include an interface extending perpendicularly to the thickness direction of the SiC film inside the SiC film.

3. The component according to claim 1 or 2,
wherein the component is a focus ring for a plasma etching apparatus.

4. The component according to claim 3,
wherein the focus ring has an outer diameter of greater or equal to 300 mm and less than or equal to 800 mm, and a thickness of greater than or equal to 3 mm and less than or equal to 20 mm.

5. The component according to claim 1 or 2,
wherein the component is a shower plate for a plasma etching apparatus.

6. The component according to claim 5,
wherein a dimension of the shower plate includes an outer diameter of greater than or equal to 300 mm and less than or equal to 800 mm, and a thickness of greater than or equal to 3 mm and less than or equal to 20 mm.

7. The component according to any one of claims 1 to 6,
wherein the component does not include a substrate and is formed of the SiC film.

8. The component according to any one of claims 1 to 6,
wherein the component includes a substrate supporting the SiC film.

9. The component according to claim 8,
wherein the substrate includes carbon, silicon (Si), a SiC sintered body, or a SiC-Si composite material.
